# EUROPEAN PATENT SPECIFICATION

(11) **EP 2 944 932 B1**
(45) Date of publication and mention of the grant of the patent: **17.05.2017**
(21) Application number: 13870565.2
(22) Date of filing: 24.12.2013
(51) Int. Cl.: G01K 7/00, H01M 10/48

(54) **METHOD FOR MEASURING TEMPERATURE OF ELECTRICAL STORAGE DEVICE**
VERFAHREN ZUR MESSUNG DER TEMPERATUR EINER STROMSPEICHERVORRICHTUNG
PROCÉDÉ DE MESURE DE TEMPÉRATURE DE DISPOSITIF DE STOCKAGE ÉLECTRIQUE

(30) Priority: 11.01.2013 JP 2013003500
(43) Date of publication of application: 18.11.2015
(73) Proprietor: Alps Electric Co., Ltd., Tokyo, 145-8501 (JP)
(72) Inventor: HEBIGUCHI, Hiroyuki, Tokyo 145-8501 (JP)
(74) Representative: Klunker . Schmitt-Nilson . Hirsch
(86) International application number: PCT/JP2013/007545
(87) International publication number: WO 2014/108971

(56) References cited:
- WO-A1-2012/054473
- JP-A- 2010 243 481
- JP-A- 2010 243 481
- JP-A- 2011 018 532
- JP-A- 2012 135 168

## Description

### Technical Field

The present invention relates to a method of measuring the temperature of an electrical storage device and particularly to an electrical storage device temperature-measuring method for accurately measuring the internal temperature of the electrical storage device.

### Background Art

Electrical storage devices such as a lithium-ion secondary battery and an electric double-layer capacitor have been used for various purposes and have been widely applied to, for example, battery packs for mobile phones, batteries for PCs, and batteries for vehicles. In such cases, detection of a state of an electrical storage device such as a deterioration state (referred to as SOH; state of health) and a remaining capacity (referred to as SOC; state of charge) is a very important matter. In particular, with regard to vehicles, detection of the state of an electrical storage device in a vehicle such as an energy-saving vehicle or a hybrid vehicle, which has a start-stop system, or in an electric vehicle is strongly associated with vehicle travelling and is therefore drawing attention as being very important.

In a generally well-known method for detecting the state of such an electrical storage device, the voltage, the current, and the temperature of the electrical storage device are measured, and the deterioration state (SOH), the remaining capacity (SOC), or the like of the electrical storage device is measured on the basis of the measurement result. Among these, the temperature of the electrical storage device is an important measurement parameter since temperature has a great influence on deterioration of the electrical storage device.

As a known technique for a method of measuring the temperature of an electrical storage device, a method is generally known in which a temperature detection element is in contact with or connected to the electrical storage device to directly measure the temperature (see, for example, PTL 1). In the method of PTL 1, a Zener diode is used as a temperature detection element and connected to the positive terminal of the electrical storage device, such that the heat transmitted from the positive terminal of the electrical storage device can be accurately measured. However, the measurement method of PTL 1 has a problem in that, due to self-heating or the like of an internal resistor of the electrical storage device, a great difference may occur between the temperature of a temperature detection point of the temperature detection element (the positive terminal of the electrical storage device in Known Example 1) and the internal temperature of the electrical storage device, and thus it is difficult to accurately determine the temperature of the electrical storage device.

In addition, in a proposed temperature detecting method, a characteristics map representing the relationship of the internal resistance (internal impedance), the remaining capacity (SOC), and the temperature of an electrical storage device is obtained in advance, and the temperature of the electrical storage device is determined by applying, to the characteristics map, the remaining capacity (SOC) and the internal resistance (internal impedance) measured during temperature detection (see, for example, PTL 2).

### Citation List

### Patent Literature

PTL 1: Japanese Unexamined Patent Application Publication No. 6-260215
PTL 2: Japanese Unexamined Patent Application Publication No. 2001-85071

Further related methods for measuring the temperature of electrical storage devices are disclosed in WO 2012/054473 and JP 2010 243481.

### Summary of Invention

### Technical Problem

In the temperature detecting method described in PTL 2, however, the remaining capacity (SOC) of the electrical storage device is independently calculated by adding up the values of the currents flowing through the electrical storage device. After the addition, the temperature of the electrical storage device is obtained on the basis of the calculated remaining capacity (SOC) and the internal resistance defined in the above-described characteristics map. This leads to a problem of complex processing being required for obtaining the temperature of the electrical storage device.

The present invention has been made in view of the above-described respects and aims to provide a method for measuring the temperature of an electrical storage device, the method enabling accurate measurement of the internal temperature of the electrical storage device without the need for complex computational processing.

### Solution to Problem

An electrical storage device temperature-measuring method according to the present invention includes: measuring a real part of internal impedance of an electrical storage device by using an alternating-current signal having a frequency band in which the real part of the internal impedance of the electrical storage device does not change according to a remaining capacity (SOC: state of charge) of the electrical storage device; and calculating internal temperature of the electrical storage device from a measured value of the real part of the internal impedance.

According to this method, the real part of the internal impedance of the electrical storage device is measured by using an alternating-current signal having a frequency band in which the real part of the internal impedance of the electrical storage device does not change. This makes it possible to measure the real part of the internal impedance of the electrical storage device, which is likely to depend only on the internal temperature of the electrical storage device, such that the internal temperature of the electrical storage device can be accurately measured. At the same time, since the real part of the internal impedance of the electrical storage device is measured by using an alternating-current signal having a frequency at which the real part of the internal impedance of the electrical storage device does not change, the remaining capacity of the electrical storage device does not need to be calculated independently. For this reason, the internal temperature of the electrical storage device can be accurately measured without the need for complex computational processing.

In the above electrical storage device temperature-measuring method, preferably, the real part of the internal impedance of the electrical storage device is measured by using an alternating-current signal having a frequency band between 100 KHz and 1 MHz inclusive, and the internal temperature of the electrical storage device is calculated from a measured value of the real part of the internal impedance. By measuring the real part of the internal impedance of the electrical storage device by using an alternating-current signal in the frequency band between 100 KHz and 1 MHz inclusive as described above, the real part of the internal impedance of the electrical storage device, which is likely to depend only on the internal temperature of the electrical storage device, can be measured effectively.

In the above electrical storage device temperature-measuring method, particularly preferably, the real part of the internal impedance of the electrical storage device is measured by using an alternating-current signal having a frequency of 300 KHz, and the internal temperature of the electrical storage device is calculated from a measured value of the real part of the internal impedance. By measuring the real part of the internal impedance of the electrical storage device by using an alternating-current signal having a frequency of 300 KHz as described above, the real part of the internal impedance of the electrical storage device, which depends only on the internal temperature of the electrical storage device, can be accurately measured.

The electrical storage device temperature-measuring method of the present invention includes: measuring internal impedance of an electrical storage device by using an alternating-current signal having a frequency band in which the internal impedance of the electrical storage device does not change according to a remaining capacity (SOC: state of charge) of the electrical storage device; and calculating internal temperature of the electrical storage device from a measured value of the internal impedance.

According to this method, the internal impedance of the electrical storage device is measured by using an alternating-current signal having a frequency band in which the internal impedance of the electrical storage device does not change. This makes it possible to measure the internal impedance of the electrical storage device, which is likely to depend only on the internal temperature of the electrical storage device, such that the internal temperature of the electrical storage device can be accurately measured. At the same time, since the internal impedance of the electrical storage device is measured by using an alternating-current signal having a frequency at which the internal impedance of the electrical storage device does not change, the remaining capacity of the electrical storage device does not need to be calculated independently. For this reason, the internal temperature of the electrical storage device can be accurately measured without the need for complex computational processing.

In the above electrical storage device temperature-measuring method, preferably the internal impedance of the electrical storage device is measured by using an alternating-current signal having a frequency band between 10 KHz and 100 KHz inclusive, and the internal temperature of the electrical storage device is calculated from a measured value of the internal impedance. By measuring the internal impedance of the electrical storage device by using an alternating-current signal in the frequency band between 10 KHz and 100 KHz inclusive as described above, the internal impedance of the electrical storage device, which is likely to depend only on the internal temperature of the electrical storage device, can be measured effectively.

In the above electrical storage device temperature-measuring method, particularly preferably, the internal impedance of the electrical storage device is measured by using an alternating-current signal having a frequency of 30 KHz, and the internal temperature of the electrical storage device is calculated from a measured value of the internal impedance. By measuring the internal impedance of the electrical storage device by using an alternating-current signal having a frequency of 30 KHz as described above, the internal impedance of the electrical storage device, which depends only on the internal temperature of the electrical storage device, can be accurately measured.

In addition, in the above electrical storage device temperature-measuring method, preferably, the alternating-current signal is superimposed on a direct current to be used for charging or discharging the electrical storage device. In this case, an alternating-current signal to be used for measuring the internal temperature of the electrical storage device is superimposed on a direct current to be used for charging or discharging the electrical storage device. This makes it possible to measure the internal impedance or the real part of the internal impedance of the electrical storage device by using the above-described alternating-current signal, while charging or discharging the electrical storage device.

In addition, in the above electrical storage device temperature-measuring method, preferably, the electrical storage device includes a current detection unit and a voltage detection unit for detecting the alternating-current signal, and at least one of the current detection unit and the voltage detection unit is used for calculation of the remaining capacity of the electrical storage device. In this case, at least one of the current detection unit and the voltage detection unit for detecting an alternating-current signal to be used for measuring the internal temperature of the electrical storage device is used to calculate the remaining capacity of the electrical storage device. Accordingly, the component (the current detection unit or the voltage detection unit) to be used for calculation of the remaining capacity of the electrical storage device is also used for the measurement of the internal temperature of the electrical storage device. This makes it possible to accurately measure the internal temperature of the electrical storage device with a reduced number of components for measuring the internal temperature of the electrical storage device.

In addition, in the above electrical storage device temperature-measuring method, preferably, a plurality of electrical storage devices each corresponding to the electrical storage device are connected in series, and the current detection unit, which is a single one, is connected to the plurality of electrical storage devices in series and the voltage detection unit is provided for each of the electrical storage devices. In this case, the single current detection unit is connected to the plurality of serially connected electrical storage devices. Accordingly, the current detection unit can be used for all of the plurality of electrical storage devices. This makes it possible to accurately measure the internal temperatures of the electrical storage devices with a reduced number of components for measuring the internal temperatures of the electrical storage devices.

### Advantageous Effects of Invention

According to the present invention, it is possible to accurately measure the internal temperature of an electrical storage device without the need for complex computational processing.

### Brief Description of Drawings

[Fig. 1] Fig. 1 is a schematic diagram illustrating an example of a configuration of a measuring system to which an electrical storage device temperature-measuring method according to an embodiment of the present invention is applied.
[Fig. 2] Fig. 2 is a schematic diagram of a configuration of a lithium-ion secondary battery forming an electrical storage device of the measuring system according to the embodiment.
[Fig. 3] Fig. 3 is an example of a graph presenting temperature dependence of the real part of internal impedance of the electrical storage device in the measuring system according to the embodiment.
[Fig. 4] Fig. 4 is an example of a graph presenting the remaining-capacity (SOC) dependence of the real part of the internal impedance of the electrical storage device in the measuring system according to the embodiment.
[Fig. 5] Fig. 5 is an example of a graph presenting an influence of the temperature and the remaining capacity (SOC) on the real part of the internal impedance of the electrical storage device in the measuring system according to the embodiment.
[Fig. 6] Fig. 6 is an example of a graph presenting temperature dependence of internal impedance of the electrical storage device in a measuring system according to a modified example of the embodiment.
[Fig. 7] Fig. 7 is an example of a graph presenting the dependence of a remaining capacity (SOC) of the internal impedance of the electrical storage device in the measuring system according to the modified example of the embodiment.
[Fig. 8] Fig. 8 is an example of a graph presenting an influence of the temperature and the remaining capacity (SOC) on the internal impedance of the electrical storage device in the measuring system according to the modified example of the embodiment.
[Fig. 9] Fig. 9 is a schematic diagram illustrating an example of a preferable configuration of the measuring system to which the electrical storage device temperature-measuring method according to the embodiment is applied. Description of Embodiments

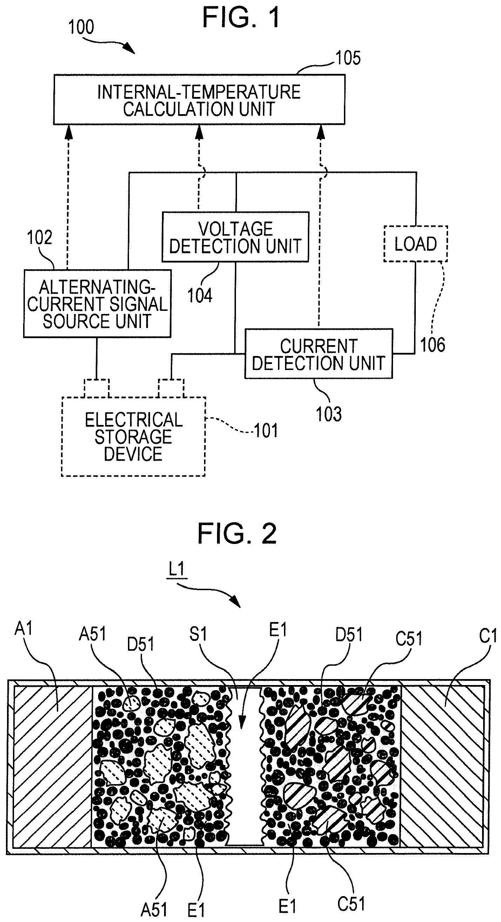

Fig. 1 is a schematic diagram illustrating an example of a configuration of a measuring system to which an electrical storage device temperature-measuring method according to an embodiment of the present invention is applied. Fig. 2 is a schematic diagram of a configuration of a lithium-ion secondary battery forming an electrical storage device of the measuring system according to the embodiment. The electrical storage device temperature-measuring method according to this embodiment is a method performed by using, for example, a measuring system 100 for measuring the internal temperature of an electrical storage device 101 illustrated in Fig. 1.

As illustrated in Fig. 1, the measuring system 100 includes an alternating-current signal source unit 102 for providing an alternating-current signal in a predetermined frequency band to the electrical storage device 101, a current detection unit 103 and a voltage detection unit 104 for detecting a current and a voltage responding to the alternating-current signal in the predetermined frequency band, and an internal-temperature calculation unit 105 for calculating the internal temperature of the electrical storage device 101 by using the alternating-current signal in the predetermined frequency band as well as the detected current and voltage.

The electrical storage device 101 is, for example, a rechargeable chemical battery such as a lithium-ion secondary battery and also includes a device that can store electrical energy by using ions, such as an electric double-layer capacitor. In general, the electrical storage device 101 mainly includes a positive electrode collector A1, a negative electrode collector C1, an electrolyte E1, and a separator S1. For example, in the case of a lithium-ion secondary battery L1, the electrical storage device 101 includes, in addition to the above components, a positive-electrode active material A51, which is a material for storing electricity on the positive electrode collector A1 side, a negative-electrode active material C51, which is a material for storing electricity on the negative electrode collector C1 side, an electrical conduction assistant D51, which is added in order to make electricity flow easily, and a binding agent, which is a binder, as illustrated in Fig. 2.

In the case of the lithium-ion secondary battery L1, mainly aluminum (Al) is used as the positive electrode collector A1, mainly copper (Cu) is used as the negative electrode collector C1, mainly a solution composed of an organic solvent (e.g., C4H6O3) and a lithium salt (e.g., LiPF6) is used as the electrolyte E1, mainly lithium cobalt oxide (LiCoO2) is used as the positive-electrode active material A51, and mainly carbon (C) is used as the negative-electrode active material C51. Alternatively, the positive-electrode active material A51 may be composed of nickel lithium oxide (LiNiO2), lithium manganese oxide (LiMn2O4), or olivine-type lithium phosphate (LiFePO4). As the carbon (C) of the negative-electrode active material C51, layered black lead crystal is used and is characterized by lithium being stored in an ionic state between the layers. The negative-electrode active material C51 may be composed of lithium titanate (Li4Ti5O12) silicon monoxide (SiO), an alloy of Sn, or an alloy of Si.

The alternating-current signal source unit 102 serves to generate an alternating-current signal having a frequency band in which the real part of the internal impedance of the electrical storage device 101 does not change according to the remaining capacity (SOC: state of charge) of the electrical storage device 101. Preferably, the alternating-current signal source unit 102 generates an alternating-current signal in the frequency band between 100 KHz and 1 MHz inclusive, for example. More preferably, the alternating-current signal source unit 102 generates an alternating-current signal having a frequency of 300 KHz. Note that a description is given later of the frequency band of the alternating-current signal generated by the alternating-current signal source unit 102.

The current detection unit 103 is connected in a circuit to which the electrical storage device 101 is connected and a load 106 is applied. The current detection unit 103 mainly includes a current sensor for detecting a current and a control circuit for the current sensor and detects a current flowing through the circuit. As the current sensor, for example, a small-size current sensor using a magnetoresistive element can be used. The voltage detection unit 104 mainly includes a voltage sensor for detecting a voltage and a control circuit for the voltage sensor, and detects the voltage of the electrical storage device 101.

The internal-temperature calculation unit 105 measures the real part of the internal impedance (internal resistance) of the electrical storage device 101 by using the alternating-current signal in the predetermined frequency band received from the alternating-current signal source unit 102, and the current and voltage detected by the current detection unit 103 and the voltage detection unit 104. The internal-temperature calculation unit 105 calculates the internal temperature of the electrical storage device 101 from the measured value of the real part of the internal impedance. The load 106 includes a power converter such as an inverter for converting a direct-current power from the electrical storage device 101 into an alternating-current power or a converter such as a DC-DC converter, for example.

It is well-known that the internal temperature and the remaining capacity (SOC) of the electrical storage device 101 greatly affect the internal impedance of the electrical storage device 101. A description is given below of the temperature dependence and the SOC dependence of the internal impedance of the electrical storage device 101. In the following description, the real part of the internal impedance of the electrical storage device 101 is referred to as the internal resistance of the electrical storage device 101 below as appropriate.

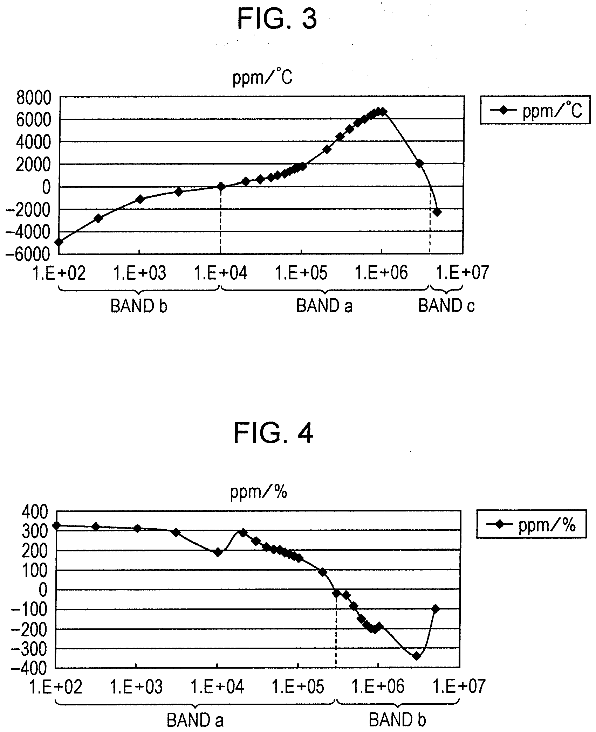

Fig. 3 is an example of a graph presenting the temperature dependence of the real part of the internal impedance of the electrical storage device 101 in the measuring system 100 according to this embodiment. Fig. 4 is an example of a graph presenting the SOC dependence of the real part of the internal impedance of the electrical storage device 101 in the measuring system 100 according to this embodiment. In Fig. 3 and Fig. 4, the frequency of an alternating-current signal provided to the electrical storage device 101 is plotted on the horizontal axis, and the internal resistance of the electrical storage device 101 is plotted on the vertical axis.

Fig. 3 presents the coefficient indicating the influence of the internal temperature on the internal resistance of the electrical storage device 101 (temperature coefficient). As presented in Fig. 3, the temperature coefficient indicates that the internal resistance increases as the temperature increases in the case of an alternating-current signal in the frequency band between 10 KHz and 3 MHz inclusive (band a shown in Fig. 3) and that the internal resistance decreases as the temperature increases in the case of an alternating-current signal in the frequency band excluding the above (in the frequency band lower than 10 KHz (band b shown in Fig. 3) and the frequency band higher than 3 MHz (band c shown in Fig. 3)). In other words, the temperature dependence is positive in the former frequency band whereas the temperature dependence is negative in the latter frequency band.

Fig. 4 presents the coefficient indicating the influence of the SOC on the internal resistance of the electrical storage device 101 (SOC coefficient). As presented in Fig. 4, the SOC coefficient indicates that the internal resistance increases as the SOC increases regarding an alternating-current signal in the frequency band lower than 300 KHz (band a shown in Fig. 4) and that the internal resistance decreases as the SOC increases regarding an alternating-current signal in the frequency band higher than 300 KHz (band b shown in Fig. 4). In other words, the SOC dependence is positive in the former frequency band whereas the SOC dependence is negative in the latter frequency band. In this case, the SOC dependence switches from positive dependence to negative dependence in alternating-current signals each having a frequency of around 300 KHz. In other words, an alternating-current signal having a frequency of around 300 KHz is close to the state of having no SOC influence on the internal resistance of the electrical storage device 101.

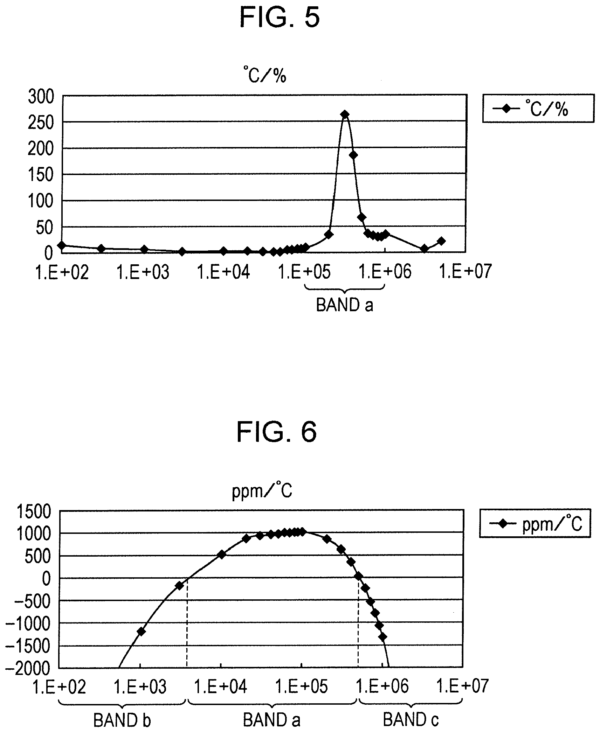

Fig. 5 is an example of a graph presenting the influence of the internal temperature and the remaining capacity (SOC) of the electrical storage device 101 on the real part of the internal impedance of the electrical storage device 101 in the measuring system 100 according to this embodiment. In Fig. 5, the frequency of an alternating-current signal provided to the electrical storage device 101 is plotted on the horizontal axis, and the value obtained by dividing the influence of the internal temperature of the electrical storage device 101 by the influence of the SOC of the electrical storage device 101 (internal temperature / SOC) is plotted on the vertical axis.

Fig. 5 presents the coefficient indicating the influence of the internal temperature and the remaining capacity (SOC) on the internal resistance of the electrical storage device 101 (temperature/SOC coefficient). As presented in Fig. 5, the temperature/SOC coefficient has a large value in the case of an alternating-current signal in the frequency band between 100 KHz and 1 MHz inclusive (band a shown in Fig. 5) compared with one in the frequency band excluding the above and has the largest value in the case of an alternating-current signal having a frequency of 300 KHz. This is because, as shown in Fig. 4, an alternating-current signal having a frequency of around 300 KHz is close to the state of having no SOC influence on the internal resistance of the electrical storage device 101. This indicates that the internal temperature of the electrical storage device 101 can be measured without having any great influence of the SOC, by using an alternating-current signal in the frequency band between 100 KHz and 1 MHz inclusive (in particular, an alternating-current signal having a frequency of around 300 KHz).

In the electrical storage device temperature-measuring method according to this embodiment, such an alternating-current signal having a frequency band in which the alternating-current signal is close to a state of having no SOC influence on the internal resistance of the electrical storage device 101 is defined as an alternating-current signal in a frequency band in which the real part of the internal impedance of the electrical storage device 101 does not change according to the SOC of the electrical storage device 101. The real part of the internal impedance of the electrical storage device 101 is measured by using an alternating-current signal in such a frequency band, and the internal temperature of the electrical storage device 101 is calculated from the measured value of the real part of the internal impedance.

As described above, in the electrical storage device temperature-measuring method according to this embodiment, the real part of the internal impedance of the electrical storage device 101 is measured by using an alternating-current signal having a frequency band in which the real part of the internal impedance of the electrical storage device 101 does not change. This makes it possible to measure the real part of the internal impedance of the electrical storage device 101, which is likely to depend only on the internal temperature of the electrical storage device 101, such that the internal temperature of the electrical storage device 101 can be accurately measured. At the same time, since the real part of the internal impedance of the electrical storage device 101 is measured by using an alternating-current signal having a frequency at which the real part of the internal impedance of the electrical storage device 101 does not change, the remaining capacity of the electrical storage device 101 does not need to be calculated independently. For this reason, the internal temperature of the electrical storage device 101 can be accurately measured without the need for complex computational processing.

More specifically, in the electrical storage device temperature-measuring method according to this embodiment, the real part of the internal impedance of the electrical storage device 101 is measured by using an alternating-current signal in the frequency band between 100 KHz and 1 MHz inclusive, and the internal temperature of the electrical storage device 101 is calculated from the measured value of the real part of the internal impedance. By measuring the real part of the internal impedance of the electrical storage device 101 by using an alternating-current signal in the frequency band between 100 KHz and 1 MHz inclusive, the real part of the internal impedance of the electrical storage device, which is likely to depend only on the internal temperature of the electrical storage device, can be measured effectively.

In particular, in the electrical storage device temperature-measuring method according to this embodiment, the real part of the internal impedance of the electrical storage device 101 is measured by using an alternating-current signal having a frequency of 300 KHz, and the internal temperature of the electrical storage device 101 is calculated from the measured value of the real part of the internal impedance. By measuring the real part of the internal impedance of the electrical storage device 101 by using an alternating-current signal having a frequency of 300 KHz, the real part of the internal impedance of the electrical storage device 101, which depends only on the internal temperature of the electrical storage device 101, can be accurately measured.

In the electrical storage device temperature-measuring method according to this embodiment, a description is given of the case where the real part of the internal impedance of the electrical storage device 101 is measured by using an alternating-current signal having a frequency band in which the real part of the internal impedance of the electrical storage device 101 does not change according to the SOC of the electrical storage device 101 and where the internal temperature of the electrical storage device 101 is calculated from the measured value of the real part of the internal impedance. However, the internal impedance itself, instead of the real part of the internal impedance, may be set as a measurement target in the electrical storage device temperature-measuring method according to this embodiment.

A modified example in which the internal impedance itself is set as a measurement target is described below. In an electrical storage device temperature-measuring method according to the modified example of this embodiment, the internal impedance of the electrical storage device 101 is measured by using an alternating-current signal having a frequency band in which the internal impedance of the electrical storage device 101 does not change according to the SOC of the electrical storage device 101, and the internal temperature of the electrical storage device 101 is calculated from the measured value of the internal impedance. The measuring system 100 illustrated in Fig. 1 can be used in the electrical storage device temperature-measuring method according to this modified example.

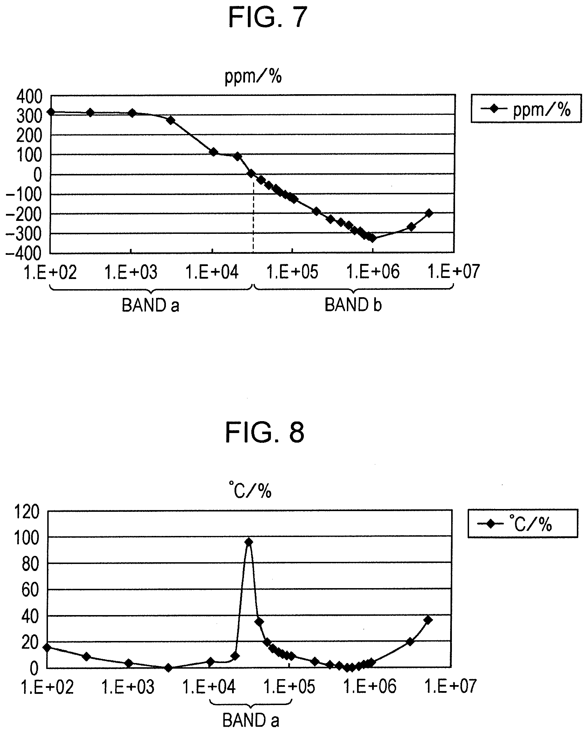

Fig. 6 is an example of a graph presenting the temperature dependence of the internal impedance of the electrical storage device 101 in the measuring system 100 according to the modified example of this embodiment. Fig. 7 is an example of a graph presenting the SOC dependence of the internal impedance of the electrical storage device 101 in the measuring system 100 according to the modified example of this embodiment. In Fig. 6 and Fig. 7, the frequency of an alternating-current signal provided to the electrical storage device 101 is plotted on the horizontal axis, and the internal impedance of the electrical storage device 101 is plotted on the vertical axis.

Fig. 6 presents the coefficient indicating the influence of the internal temperature on the internal impedance of the electrical storage device 101 (temperature coefficient). As presented in Fig. 6, the temperature coefficient indicates that the internal impedance increases as the temperature increases in the case of an alternating-current signal in the frequency band between 3 KHz and 500 KHz inclusive (band a shown in Fig. 6) and that the internal impedance decreases as the temperature increases in the case of an alternating-current signal in the frequency band excluding the above (in the frequency band lower than 3 KHz (band b shown in Fig. 6) and the frequency band higher than 500 KHz (band c shown in Fig. 6). In other words, the temperature dependence is positive in the former frequency band whereas the temperature dependence is negative in the latter frequency band.

Fig. 7 presents the coefficient indicating the influence of the SOC on the internal impedance of the electrical storage device 101 (SOC coefficient). As presented in Fig. 7, the SOC coefficient indicates that the internal impedance increases as the SOC increases in the case of an alternating-current signal in the frequency band lower than 30 KHz (band a shown in Fig. 7) and that the internal impedance decreases as the SOC increases in the case of an alternating-current signal in the frequency band higher than 30 KHz (band b shown in Fig. 7). In other words, the SOC dependence is positive in the former frequency band whereas the SOC dependence is negative in the latter frequency band. In this case, the SOC dependence switches from positive dependence to negative dependence in alternating-current signals each having a frequency of around 30 KHz. In other words, an alternating-current signal having a frequency of around 30 KHz is close to the state of having no SOC influence on the internal impedance of the electrical storage device 101.

Fig. 8 is an example of a graph presenting the influence of the internal temperature and the remaining capacity (SOC) of the electrical storage device 101 on the internal impedance of the electrical storage device 101 in the measuring system 100 according to this embodiment. In Fig. 8, the frequency of an alternating-current signal provided to the electrical storage device 101 is plotted on the horizontal axis, and the value obtained by dividing the influence of the internal temperature of the electrical storage device 101 by the influence of the SOC of the electrical storage device 101 (internal temperature / SOC) is plotted on the vertical axis.

Fig. 8 presents the coefficient indicating the influence of the internal temperature and the remaining capacity (SOC) on the internal resistance of the electrical storage device 101 (temperature/SOC coefficient). As presented in Fig. 8, the temperature/SOC coefficient has a large value in the case of an alternating-current signal in the frequency band between 10 KHz and 100 KHz inclusive (band a shown in Fig. 8) compared with one in the frequency band excluding the above and has the largest value in the case of an alternating-current signal having a frequency of 30 KHz. This is because, as shown in Fig. 7, an alternating-current signal having a frequency of around 30 KHz is close to the state of having no SOC influence on the internal impedance of the electrical storage device 101. This indicates that the internal temperature of the electrical storage device 101 can be measured using an alternating-current signal in the frequency band between 10 KHz and 100 KHz inclusive (in particular, an alternating-current signal having a frequency of around 30 KHz).

In the electrical storage device temperature-measuring method according to the modified example of this embodiment, such an alternating-current signal in a frequency band in which the alternating-current signal is close to a state of having no SOC influence on the internal impedance of the electrical storage device 101 is defined as an alternating-current signal in a frequency band in which the internal impedance of the electrical storage device 101 does not change according to the SOC of the electrical storage device 101. The internal impedance of the electrical storage device 101 is measured by using an alternating-current signal in such a frequency band, and the internal temperature of the electrical storage device 101 is calculated from the measured value of the internal impedance.

As described above, in the electrical storage device temperature-measuring method according to the modified example of this embodiment, the internal impedance of the electrical storage device 101 is measured by using an alternating-current signal having a frequency band in which the internal impedance of the electrical storage device 101 does not change, as in the above-described embodiment. This makes it possible to measure the internal impedance of the electrical storage device 101, which is likely to depend only on the internal temperature of the electrical storage device 101, such that the internal temperature of the electrical storage device 101 can be accurately measured. At the same time, since the internal impedance of the electrical storage device 101 is measured by using an alternating-current signal having a frequency at which the internal impedance of the electrical storage device 101 does not change, the remaining capacity of the electrical storage device 101 does not need to be calculated independently. For this reason, the internal temperature of the electrical storage device 101 can be accurately measured without the need for complex computational processing.

More specifically, in the electrical storage device temperature-measuring method according to the modified example of this embodiment, the internal impedance of the electrical storage device 101 is measured by using an alternating-current signal in the frequency band between 10 KHz and 100 KHz inclusive, and the internal temperature of the electrical storage device 101 is calculated from the measured value of the internal impedance. By measuring the internal impedance of the electrical storage device 101 by using an alternating-current signal in the frequency band between 10 KHz and 100 KHz inclusive, the real part of the internal impedance of the electrical storage device 101, which is likely to depend only on the internal temperature of the electrical storage device 101, can be measured effectively.

In particular, in the electrical storage device temperature-measuring method according to the modified example of this embodiment, the internal impedance of the electrical storage device 101 is measured by using an alternating-current signal having a frequency of 30 KHz, and the internal temperature of the electrical storage device 101 is calculated from the measured value of the internal impedance. By measuring the internal impedance of the electrical storage device 101 by using an alternating-current signal having a frequency of 30 KHz, the internal impedance of the electrical storage device 101, which depends only on the internal temperature of the electrical storage device 101, can be accurately measured.

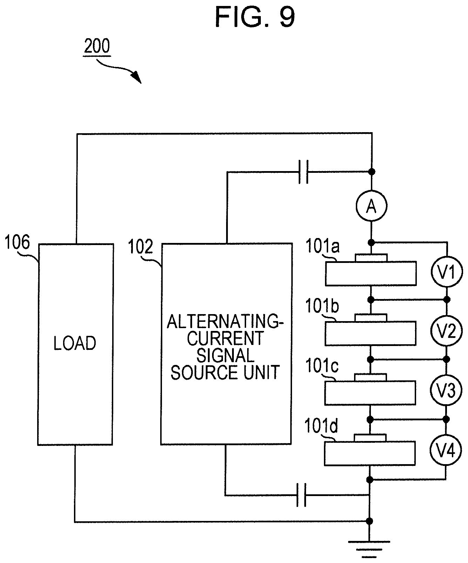

An example of a preferable configuration of a measuring system to which the electrical storage device temperature-measuring method according to this embodiment is described below. Fig. 9 is a schematic diagram illustrating an example of a preferable configuration of a measuring system 200 to which the electrical storage device temperature-measuring method according to this embodiment is applied. In Fig. 9, the same components as those in Fig. 1 are denoted by the same numerals, and a detailed description thereof is omitted. In Fig. 9, the current detection unit 103 and the voltage detection unit 104 illustrated in Fig. 1 are denoted by "A" and "V", respectively. In addition, in Fig. 9, the internal-temperature calculation unit 105 illustrated in Fig. 1 is omitted.

As illustrated in Fig. 9, multiple (four in the example illustrated in Fig. 9) electrical storage devices 101a to 101d are connected in series in the measuring system 200. A current detection unit (current sensor) A is connected in series. Voltage detection units (voltage sensors) V1 to V4 are connected respectively to the electrical storage devices 101a to 101d. In the measuring system 200, the alternating-current signal transmission source unit 102 is connected in parallel to the load 106 via capacitors.

The current detection unit A detects a current flowing through the circuit. The voltage detection units V1 to V4 detect the voltages of the respective electrical storage devices 101a to 101d. In this case, the current detection unit A and the voltage detection units V1 to V4 are used to detect an alternating-current signal generated by the alternating-current signal transmission source unit 102. At the same time, at least one of the current detection unit A and the voltage detection unit V (V1 to V4) is used to calculate the remaining capacities of the electrical storage devices 101a to 101d.

In the electrical-storage device temperature measuring method to which the measuring system 200 illustrated in Fig. 9 is applied, an alternating-current signal generated by the alternating-current signal source unit 102 is superimposed on a direct current to be used for charging or discharging the electrical storage devices 101a to 101d. Accordingly, an alternating-current signal to be used for measuring the internal temperatures of the electrical storage devices 101a to 101d is superimposed on a direct current to be used for charging or discharging the electrical storage devices 101a to 101d. This makes it possible to measure the internal impedances of the electrical storage devices 101a to 101d by using the above-described alternating-current signal, while charging or discharging the electrical storage devices 101a to 101d.

In the electrical-storage device temperature measuring method to which the measuring system 200 is applied, at least one of the current detection unit A and the voltage detection unit V (V1 to V4) for detecting an alternating-current signal to be used for measuring the internal temperatures of the electrical storage devices 101a to 101d is used to calculate the remaining quantities (SOCs) of the electrical storage devices 101a to 101d. Accordingly, the components to be used for calculation of the remaining quantities of the electrical storage devices 101a to 101d (the current detection unit A or the voltage detection unit V (V1 to V4)) are also used for measuring the internal temperatures of the electrical storage devices 101a to 101d. This makes it possible to accurately measure the internal temperatures of the electrical storage devices 101a to 101d with a reduced number of components in the electrical storage devices 101a to 101d.

In addition, the single current detection unit A is connected in series to the multiple serially connected electrical storage devices 101a to 101d in the electrical-storage device temperature measuring method to which the measuring system 200 is applied. Accordingly, the current detection unit A can be used for all of the multiple electrical storage devices 101a to 101d. This makes it possible to accurately measure the internal temperatures of the electrical storage devices 101a to 101d with a reduced number of components in the electrical storage devices 101a to 101d.

A description is given above of the case in which the measuring system 200 illustrated in Fig. 9 is applied to the mode of measuring the internal impedances of the electrical storage devices 101a to 101d as described in the above embodiment. However, the mode to which the measuring system 200 illustrated in Fig. 9 is applied is not limited to this, and the measuring system 200 is also applicable to a mode of measuring the real parts of the internal impedances of the electrical storage devices 101a to 101d as in the above embodiment. For example, by adding a lock-in detection circuit and a lock-in amplifier, although not illustrated, phases can be accurately obtained and weak signals can be accurately measured, thereby making further accurate measurement of internal temperatures possible.

The present invention is not limited to the above embodiment, and various changes can be made to the above embodiment. For example, changes can be made to the above embodiment in terms of the connection relationship and sizes of the elements as appropriate as long as the gist of the present invention is not changed. The configuration, method, and the like described in the embodiment can be implemented in combination as appropriate.

### Industrial Applicability

The electrical storage device temperature-measuring method of the present invention is useful in obtaining the state of health (SOH) and the remaining capacity (SOC) of an electrical storage device.

### Reference Signs List

- 100,: 200 measuring system
- 101, 101a to 101d: electrical storage device
- 102: alternating-current signal source unit
- 103,: A current detection unit
- 104, V1 to V4: voltage detection unit
- 105: internal-temperature calculation unit
- 106: load

## Claims

1. An electrical storage device temperature-measuring method comprising:
measuring a real part of internal impedance of an electrical storage device (101) by using an alternating-current signal having a frequency band in which the real part of the internal impedance of the electrical storage device (101) does not change according to a remaining capacity, i.e. SOC : state of charge, of the electrical storage device (101); and
calculating internal temperature of the electrical storage device (101) from a measured value of the real part of the internal impedance.

2. The electrical storage device temperature-measuring method according to Claim 1,
wherein the real part of the internal impedance of the electrical storage device (101) is measured by using an alternating-current signal having a frequency band between 100 KHz and 1 MHz inclusive, and
wherein the internal temperature of the electrical storage device (101) is calculated from a measured value of the real part of the internal impedance.

3. The electrical storage device temperature-measuring method according to Claim 1,
wherein the real part of the internal impedance of the electrical storage device (101) is measured by using an alternating-current signal having a frequency of 300 KHz, and
wherein the internal temperature of the electrical storage device (101) is calculated from a measured value of the real part of the internal impedance.

4. An electrical storage device temperature-measuring method comprising:
measuring internal impedance of an electrical storage device (101) by using an alternating-current signal having a frequency band in which the internal impedance of the electrical storage device (101) does not change according to a remaining capacity, i.e. SOC: state of charge, of the electrical storage device; and
calculating internal temperature of the electrical storage device (101) from a measured value of the internal impedance.

5. The electrical storage device temperature-measuring method according to Claim 4,
wherein the internal impedance of the electrical storage device (101) is measured by using an alternating-current signal having a frequency band between 10 KHz and 100 KHz inclusive, and
wherein the internal temperature of the electrical storage device (101) is calculated from a measured value of the internal impedance.

6. The electrical storage device temperature-measuring method according to Claim 4, wherein the internal impedance of the electrical storage device (101) is measured by using an alternating-current signal having a frequency of 30 KHz, and
wherein the internal temperature of the electrical storage device (101) is calculated from a measured value of the internal impedance.

7. The electrical storage device temperature-measuring method according to any one of Claims 1 to 6, wherein the alternating-current signal is superimposed on a direct current to be used for charging or discharging the electrical storage device (101).

8. The electrical storage device temperature-measuring method according to any one of Claims 1 to 7, wherein the electrical storage device (101) includes a current detection unit (103) and a voltage detection unit (104) for detecting the alternating-current signal, and
wherein at least one of the current detection unit (103) and the voltage detection unit (104) is used for calculating the remaining capacity of the electrical storage device (101) .

9. The electrical storage device temperature-measuring method according to Claim 8, wherein a plurality of electrical storage devices (101a, 101b, 101c, 101d) each corresponding to the electrical storage device (101) are connected in series, and wherein the current detection unit (103, A), which is a single one, is connected in series to the plurality of electrical storage devices (101a, 101b, 101c, 101d), and one voltage detection unit (V1, V2, V3, V4) is provided for each of the electrical storage devices (101a, 101b, 101c, 101d).

## Patentansprüche

1. Verfahren zur Messung der Temperatur einer elektrischen Speichervorrichtung, das folgende Schritte aufweist:
Messen eines Realteils der internen Impedanz einer elektrischen Speichervorrichtung (101) unter Verwendung eines Wechselstromsignals mit einem Frequenzband, in dem sich der Realteil der internen Impedanz der elektrischen Speichervorrichtung (101) nicht in Abhängigkeit von einer Restkapazität, d.h. SOC: Ladezustand, der elektrischen Speichervorrichtung (101) ändert; und
Berechnen der Innentemperatur der elektrischen Speichervorrichtung (101) aus einem Messwert des Realteils der internen Impedanz.

2. Verfahren zur Messung der Temperatur einer elektrischen Speichervorrichtung nach Anspruch 1,
wobei der Realteil der internen Impedanz der elektrischen Speichervorrichtung (101) unter Verwendung eines Wechselstromsignals mit einem Frequenzband von 100 kHz bis 1 MHz einschließlich gemessen wird, und wobei die Innentemperatur der elektrischen Speichervorrichtung (101) aus einem Messwert des Realteils der internen Impedanz berechnet wird.

3. Verfahren zur Messung der Temperatur einer elektrischen Speichervorrichtung nach Anspruch 1,
wobei der Realteil der internen Impedanz der elektrischen Speichervorrichtung (101) unter Verwendung eines Wechselstromsignals mit einer Frequenz von 300 KHz gemessen wird, und
wobei die Innentemperatur der elektrischen Speichervorrichtung (101) aus einem Messwert des Realteils der internen Impedanz berechnet wird.

4. Verfahren zur Messung der Temperatur einer elektrischen Speichervorrichtung, das folgende Schritte aufweist:
Messen der internen Impedanz einer elektrischen Speichervorrichtung (101) unter Verwendung eines Wechselstromsignals mit einem Frequenzband, in dem sich die interne Impedanz der elektrischen Speichervorrichtung (101) nicht in Abhängigkeit von einer Restkapazität, d.h. SOC: Ladezustand, der elektrischen Speichervorrichtung ändert; und
Berechnen der Innentemperatur der elektrischen Speichervorrichtung (101) aus einem Messwert der internen Impedanz.

5. Verfahren zur Messung der Temperatur einer elektrischen Speichervorrichtung nach Anspruch 4,
wobei die interne Impedanz der elektrischen Speichervorrichtung (101) unter Verwendung eines Wechselstromsignals mit einem Frequenzband von 10 kHz bis 100 kHz einschließlich gemessen wird, und
wobei die Innentemperatur der elektrischen Speichervorrichtung (101) aus einem Messwert der internen Impedanz berechnet wird.

6. Verfahren zur Messung der Temperatur einer elektrischen Speichervorrichtung nach Anspruch 4,
wobei die interne Impedanz der elektrischen Speichervorrichtung (101) unter Verwendung eines Wechselstromsignals mit einer Frequenz von 30 kHz gemessen wird, und
wobei die Innentemperatur der elektrischen Speichervorrichtung (101) aus einem Messwert der internen Impedanz berechnet wird.

7. Verfahren zur Messung der Temperatur einer elektrischen Speichervorrichtung nach einem der Ansprüche 1 bis 6,
wobei das Wechselstromsignal einem Gleichstrom überlagert wird, der zum Laden oder Entladen der elektrischen Speichervorrichtung (101) verwendet wird.

8. Verfahren zur Messung der Temperatur einer elektrischen Speichervorrichtung nach einem der Ansprüche 1 bis 7,
wobei die elektrische Speichervorrichtung (101) eine Stromerfassungseinheit (103) und eine Spannungserfassungseinheit (104) zum Erfassen des Wechselstromsignals aufweist, und
wobei mindestens eine von der Stromerfassungseinheit (103) und der Spannungserfassungseinheit (104) zur Berechnung der Restkapazität der elektrischen Speichervorrichtung (101) verwendet wird.

9. Verfahren zur Messung der Temperatur einer elektrischen Speichervorrichtung nach Anspruch 8,
wobei mehrere elektrische Speichervorrichtungen (101a, 101b, 101c, 101d), die jeweils der elektrischen Speichervorrichtung (101) entsprechen, in Reihe geschaltet sind, und
wobei die Stromerfassungseinheit (103, A), bei der es sich um eine einzige Einheit handelt, mit den mehreren elektrischen Speichervorrichtungen (101a, 101b, 101c, 101d) in Reihe geschaltet ist und eine Spannungserfassungseinheit (V1, V2, V3, V4) für jede der elektrischen Speichervorrichtungen (101a, 101b, 101c, 101d) vorgesehen ist.

## Revendications

1. Procédé de mesure de température de dispositif de stockage électrique comprenant :
de mesurer une partie réelle d'une impédance interne d'un dispositif de stockage électrique (101) en utilisant un signal de courant alternatif ayant une bande de fréquence dans laquelle la partie réelle de l'impédance interne du dispositif de stockage électrique (101) ne change pas selon une capacité restante, c'est à dire un SOC : état de charge du dispositif de stockage électrique (101) ; et
de calculer une température interne du dispositif de stockage électrique (101) à partir d'une valeur mesurée de la partie réelle de l'impédance interne.

2. Procédé de mesure de température de dispositif de stockage électrique selon la revendication 1,
dans lequel la partie réelle de l'impédance interne du dispositif de stockage électrique (101) est mesurée en utilisant un signal de courant alternatif ayant une bande de fréquence entre 100 KHz et 1 MHz inclus, et
dans lequel la température interne du dispositif de stockage électrique (101) est calculée à partir d'une valeur mesurée de la partie réelle de l'impédance interne.

3. Procédé de mesure de température de dispositif de stockage électrique selon la revendication 1,
dans lequel la partie réelle de l'impédance interne du dispositif de stockage électrique (101) est mesurée en utilisant un signal de courant alternatif ayant une fréquence de 300 KHz, et
dans lequel la température interne du dispositif de stockage électrique (101) est calculée à partir d'une valeur mesurée de la partie réelle de l'impédance interne.

4. Procédé de mesure de température de dispositif de stockage électrique comprenant :
de mesurer une impédance interne d'un dispositif de stockage électrique (101) en utilisant un signal de courant alternatif ayant une bande de fréquence dans laquelle l'impédance interne du dispositif de stockage électrique (101) ne change pas selon une capacité restante, par exemple : c'est à dire un SOC : état de charge du dispositif de stockage électrique (101) ; et
de calculer une température interne du dispositif de stockage électrique (101) à partir d'une valeur mesurée de l'impédance interne.

5. Procédé de mesure de température de dispositif de stockage électrique selon la revendication 4,
dans lequel l'impédance interne du dispositif de stockage électrique (101) est mesurée en utilisant un signal de courant alternatif ayant une bande de fréquence entre 10 KHz et 100 KHz inclus, et
dans lequel la température interne du dispositif de stockage électrique (101) est calculée à partir d'une valeur mesurée de l'impédance interne.

6. Procédé de mesure de température de dispositif de stockage électrique selon la revendication 4,
dans lequel l'impédance interne du dispositif de stockage électrique (101) est mesurée en utilisant un signal de courant alternatif ayant une fréquence de 30 KHz, et
dans lequel la température interne du dispositif de stockage électrique (101) est calculée à partir d'une valeur mesurée de la partie réelle de l'impédance interne.

7. Procédé de mesure de température de dispositif de stockage électrique selon l'une quelconque des revendications 1 à 6, dans lequel le signal de courant alternatif est superposé sur un courant continu pour être utilisé pour charger ou décharger le dispositif de stockage électrique (101).

8. Procédé de mesure de température de dispositif de stockage électrique selon l'une quelconque des revendications 1 à 7,
dans lequel le dispositif de stockage électrique (101) inclut une unité détection de courant (103) et une unité de détection de tension (104) pour détecter le signal de courant alternatif, et
dans lequel au moins une de l'unité détection de courant (103) et de l'unité de détection de tension (104) est utilisée pour calculer la capacité restante du dispositif de stockage électrique (101).

9. Procédé de mesure de température de dispositif de stockage électrique selon la revendication 8,
dans lequel une pluralité de dispositifs de stockage électrique (101a, 101b, 101c, 101d) correspondant chacun au dispositif de stockage électrique (101) sont connectés en série, et
dans lequel l'unité détection de courant (103, A), qui est unique, est connectée en série à la pluralité de dispositifs de stockage électrique (101a, 101b, 101c, 101d), et une unité de détection de tension (V1, V2, V3, V4) est fournie pour chacun des dispositifs de stockage électrique (101a, 101b, 101c, 101d).
